# FASCICULE DE BREVET EUROPEEN

(11) **EP 0 908 535 B1**
(45) Date de publication et mention de la délivrance du brevet: **23.07.2003**
(21) Numéro de dépôt: 97203136.3
(22) Date de dépôt: 08.10.1997
(51) Int. Cl.: C23G 5/00, H01J 37/34

(54) **Procédé pour le décapage de la surface d'un substrat et installation pour la mise en oeuvre de ce procédé**
Verfahren zum Reinigen eines Substrats und Vorrichtung zur Durchführung des Verfahrens
Process for cleaning a substrate and apparatus for carrying out the process

(43) Date de publication de la demande: 14.04.1999
(73) Titulaire: RECHERCHE ET DEVELOPPEMENT DU GROUPE COCKERILL SAMBRE, en abrégé: RD-CS, 4000 Liège (BE)
(72) Inventeur: Vanden Brande, Pierre, 1040 Bruxelles (BE); Weymeersch, Alain, 1300 Wavre (BE)
(74) Mandataire: Callewaert, Jean

(56) Documents cités:
- EP-A- 0 535 568
- US-A- 2 867 912
- US-A- 4 622 094

## Description

La présente invention est relative à un procédé pour le décapage en continu de la surface d'un substrat se déplaçant dans un sens déterminé à travers une chambre sous vide en regard d'au moins une contre-électrode suivant lequel on crée, entre cette dernière et cette surface, un plasma dans un gaz qui est tel à pouvoir générer des radicaux et/ou ions agissant sur ladite surface à décaper.

Un des buts essentiels de la présente invention est de proposer un procédé très efficace pour le décapage d'une ou des deux surfaces d'un substrat contaminé par une couche mince isolante, telle qu'un film d'huile ou une couche mince d'oxyde, dont l'épaisseur est de préférence inférieure à 1 micron en faisant usage de la technique connue de pulvérisation cathodique ("sputtering") sur la surface à nettoyer.

Le problème qui se pose en général lorsqu'on applique cette technique pour décaper des substrats à nettoyer est la formation d'arcs et la coupure de l'alimentation en courant électrique par suite de la présence d'une telle couche isolante.

Ainsi, il s'est avéré que cette technique ne convient pas, jusqu'à présent, pour le décapage d'une tôle huilée sans devoir introduire dans la chambre sous vide une quantité non négligeable d'oxygène.

Suivant l'invention, ce problème a été résolu d'une façon non prévisible en faisant usage, dans la chambre sous vide dans laquelle a eu lieu la pulvérisation cathodique, d'au moins une paire de contre-électrodes successives en regard desquelles se déplace le substrat susdit et en appliquant à ces contre-électrodes un potentiel alternatif de manière à charger ces dernières alternativement positivement et négativement par rapport au substrat, ce dernier étant de préférence mis à la masse, ladite au moins une paire de contre-électrodes comprenant une première contre-électrode et une deuxième contre-électrode, la première contre-électrode étant polarisée positivement par rapport au substrat lorsque la deuxième contre-électrode l'est négativement, et inversement, tandis que, sur la surface du substrat en regard de la ou des contre-électrodes polarisées positivement par rapport à lui, a lieu un bombardement d'ions positifs issus du plasma créé entre le substrat et ce ou ces contre-électrodes.

Avantageusement, l'on prévoit, par contre-électrode précitée, un circuit magnétique disposé derrière le substrat à décaper.

Suivant une forme de réalisation particulière de l'invention, lorsque le substrat est par exemple formé par une bande métallique, l'on applique aux contre-électrodes précitées un potentiel alternatif de 50 Hz à 300 KHz et de préférence 10 KHz à 300 KHz, par exemple de l'ordre de 200 KHz.

L'invention concerne également un dispositif ou installation pour la mise en oeuvre du procédé de décapage suivant l'invention.

Cette installation comprend une chambre sous vide dans laquelle est montée une contre-électrode, des moyens de transport pour déplacer un substrat à décaper en regard de celle-ci et des moyens pour créer un plasma entre la contre-électrode et le substrat. Cette installation est caractérisée par le fait qu'elle comprend au moins une paire de contre-électrodes successives, des moyens pour appliquer à ces contre-électrodes un potentiel ou courant alternatif, de manière à charger ces dernières alternativement positivement et négativement par rapport audit substrat, les moyens pour créer un plasma permettant de créer celui-ci alternativement entre une de ces contre-électrodes et le substrat faisant face à celle-ci, ladite au moins une paire de contre-électrodes comprenant une première contre-électrode et une deuxième contre-électrode, et les moyens pour appliquer un potentiel ou courant alternatif à ces contre-électrodes étant prévus pour charger la première contre-électrode positivement et la seconde contre-électrode négativement par rapport au substrat, et inversement.

D'autres détails et particularités de l'invention ressortiront de la description donnée ci-après, à titre d'exemple non limitatif, de quelques formes de réalisation particulières de l'invention, avec référence aux dessins annexés.
La figure 1 est une vue schématique en élévation d'une première forme de réalisation d'une installation suivant l'invention pour le décapage en continu d'une tôle d'acier.
La figure 2 est une vue analogue à celle de la figure 1 d'une deuxième forme de réalisation d'une telle installation.
La figure 3 est une vue analogue à celle des figures 1 et 2 d'une troisième forme de réalisation d'une telle installation.

Dans ces figures les mêmes chiffres de référence concernent des éléments analogues ou identiques.

La présente invention concerne un procédé amélioré de décapage par pulvérisation cathodique qui convient en particulier pour le décapage de substrats conducteurs d'électricité contaminés par une couche mince électriquement isolante, telle qu'un film d'huile ou d'oxyde dont l'épaisseur est de préférence inférieure à 1 micron, ou encore pour le nettoyage de substrats de polymères.

D'une façon générale, le procédé suivant l'invention est caractérisé par le fait que l'on fait usage, dans une chambre sous vide, d'au moins une paire de contre-électrodes successives en regard de chacune desquelles se déplace le substrat susdit et auxquelles on applique un potentiel alternativement positif et négatif.

Ainsi, lorsqu'une des deux contre-électrodes est polarisée positivement par rapport à l'autre, le substrat en regard de cette contre-électrode est lui-même polarisé négativement par rapport à cette première contre-électrode avec comme conséquence qu'un bombardement d'ions positifs y a lieu.

En même temps à l'autre contre-électrode on observe la situation inverse. Cette dernière, qui est polarisée négativement, repousse les électrons du plasma qui tendent à décharger la charge superficielle positive qui s'est créée dans un cycle précédent.

Lorsque le substrat est conducteur d'électricité, l'installation permet l'érosion du substrat et non l'érosion des contre-électrodes, ceci pour autant que l'on travaille en dessous d'une fréquence critique comprise entre une et plusieurs centaines de kHz en fonction des conditions de travail (par exemple pression dans la chambre). En effet, en dessous de cette fréquence maximum d'exécution, la décharge se comporte comme une décharge en courant continu dans chaque demi-cycle. Ainsi, un plasma stable ne peut se former qu'au voisinage de l'électrode polarisée négativement lorsqu'elle est pourvue d'un circuit magnétique disposé du côté opposé à celui de l'électrode lui faisant face, de manière à constituer un dispositif de type magnétron pouvant confiner les électrons. Les circuits magnétiques étant disposés à proximité du substrat et du côté opposé à celui des contre-électrodes, une décharge se forme au voisinage du substrat lorsqu'il est polarisé négativement par rapport à l'une des contre-électrodes alors qu'aucune décharge ne peut se former de manière stable au voisinage d'une contre-électrode polarisée négativement par rapport au substrat puisque cette dernière ne dispose pas d'un circuit magnétique permettant de constituer un dispositif de type magnétron, c'est-à-dire permettant de confiner les électrons dans son voisinage.

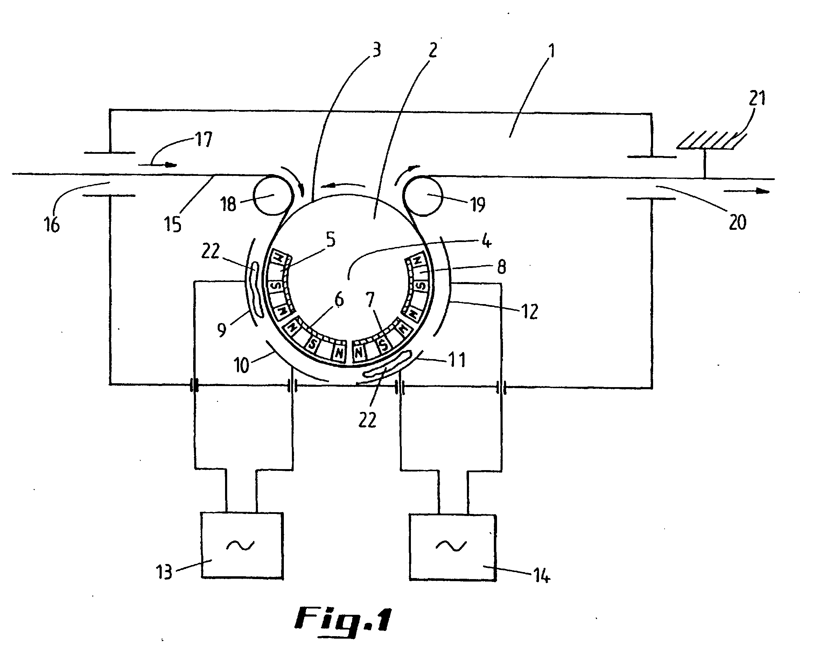

La figure 1 montre schématiquement une première forme de réalisation d'une installation permettant la mise en oeuvre du procédé suivant l'invention.

Cette installation comprend une chambre sous vide 1 dans laquelle est monté un tambour 2 présentant une surface cylindrique 3 et pouvant tourner autour d'un axe 4.

A l'intérieur de ce tambour 2 sont montés quatre magnétrons fixes 5 à 8 s'étendant à proximité de la face intérieure de la paroi cylindrique du tambour et permettant de générer un circuit magnétique. Deux paires de contre-électrodes successives 9, 10 et 11, 12 sont disposées à l'extérieur du tambour 2, à une distance constante de la surface cylindrique 3 de ce dernier. Ces contre-électrodes s'étendent suivant une surface cylindrique coaxiale au tambour 2. Chaque paire de contre-électrodes 9,10 et 11, 12 est alimentée par un générateur de courant alternatif respectivement 13 et 14.

Un substrat formé, dans ce cas particulier, par une tôle ou bande d'acier continue 15 entre la chambre sous vide 1 par une ouverture d'entrée 16 prévue dans une des parois latérales de cette chambre et se déplace à travers cette dernière 1 dans le sens de la flèche 17 en étant déviée autour d'un premier cylindre de renvoi 18 à rotation libre autour d'un axe parallèle à celui du tambour pour être appliqué contre la face extérieure cylindrique 3 de ce dernier et être déviée autour d'un deuxième cylindre de renvoi 19 vers une sortie 20 prévue dans la paroi opposée à celle dans laquelle est prévue l'ouverture d'entrée 16.

Dans cette forme de réalisation particulière, la tôle 15 est mise à la masse, comme indiqué schématiquement en 21.

La chambre contient généralement un mélange gazeux d'argon et d'un gaz réactif, par exemple, hydrogène ou oxygène, dont le rapport peut varier entre des limites très larges.

Avantageusement, il n'y a pas de séparation entre deux électrodes successives de manière à permettre un libre passage des particules chargées se trouvant en regard d'une zone de contre-électrode vers l'autre zone.

Ainsi, au moment où la contre-électrode 9 ou 11, par exemple, est polarisée positivement, la partie de la tôle 15 passant en regard de cette électrode est polarisée négativement et un plasma 22 y est formé et confiné par la présence des circuits magnétiques 5 et 7 résultant en un bombardement de la tôle 15 par des ions positifs.

En même temps, les contre-électrodes 10 et 12, qui sont polarisées négativement, repoussent les électrons vers le substrat assurant ainsi le retour de courant.

Etant donné donc que dans un stade suivant les contre-électrodes 9 et 11 sont chargées négativement et les contre-électrodes 10 et 12 sont polarisées positivement, le phénomène décrit ci-dessus est inversé.

Avantageusement, on impose aux contre-électrodes 9 à 12 alternativement un potentiel positif et négatif présentant sensiblement la même valeur absolue par rapport au potentiel du substrat, tel qu'un potentiel variant sinusoïdalement par rapport à celui du substrat qui est de préférence maintenu à la masse, comme déjà mentionné ci-dessus.

Généralement, l'on applique à ces contre-électrodes 9 à 12, par l'intermédiaire de générateurs de courant 13 et 14, un potentiel alternatif ayant une fréquence de 1 KHz à 1000 KHz.

Lorsque la surface du substrat à décaper est électriquement conductrice et est, par exemple, formée d'une tôle, de bons résultats sont obtenus lorsqu'on applique aux contre-électrodes 9 à 11 un potentiel alternatif de 50 Hz à 300 KHz et de préférence de 10 KHz à 300 KHz, par exemple de l'ordre de 200 KHz.

Par contre, si le substrat est non conducteur et est par exemple formé par un film polymère, la fréquence du potentiel alternatif appliqué aux contre-électrodes peut, dans certains cas, atteindre 1000 KHz.

La distance entre le substrat 15 et les contre-électrodes 9 à 12 varie généralement entre 1 et 20 cm.

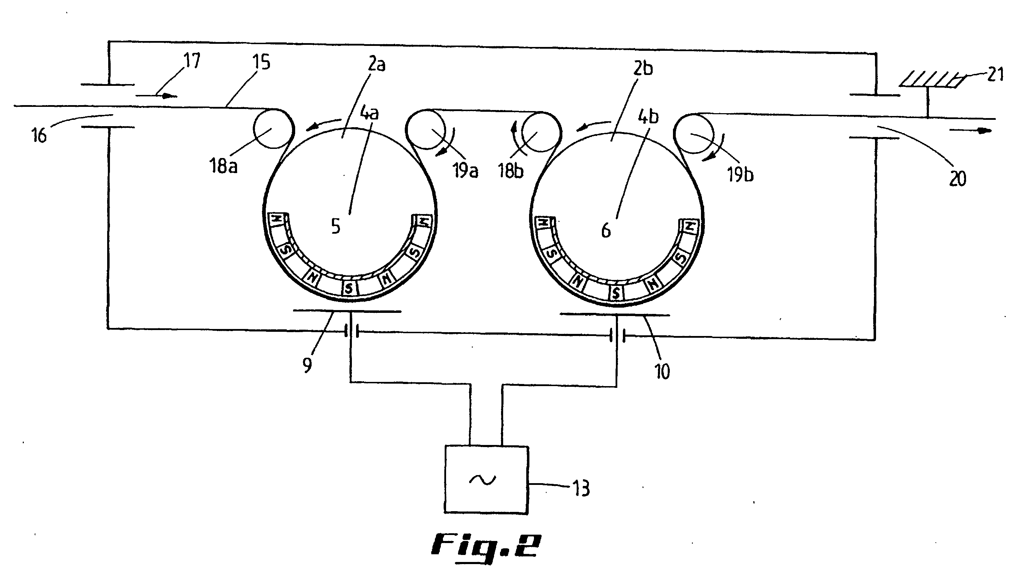

La figure 2 concerne une deuxième forme de réalisation d'une installation qui se distingue par rapport à celle de la figure 1 par le fait que la chambre sous vide 1 comprend deux tambours 2a et 2b de dimensions identiques et tournant autour d'axes parallèles 4a et 4b. De plus, seulement une paire de contre-électrodes 9 et 10 est prévue présentant chacune une forme plane.

Une de ces contre-électrodes 9 s'étend en regard du tambour 2a, tandis que la contre-électrode 10 s'étend en regard du tambour 2b.

Comme dans la forme de réalisation suivant la figure 1, le substrat 15 est formé d'une bande continue déviée successivement autour de chacun des deux tambours 2a et 2b par l'intermédiaire de cylindres de renvoi 18a, 19a et 18b, 19b. Pour le restant, leur fonctionnement est entièrement identique à celui de l'installation de la figure 1.

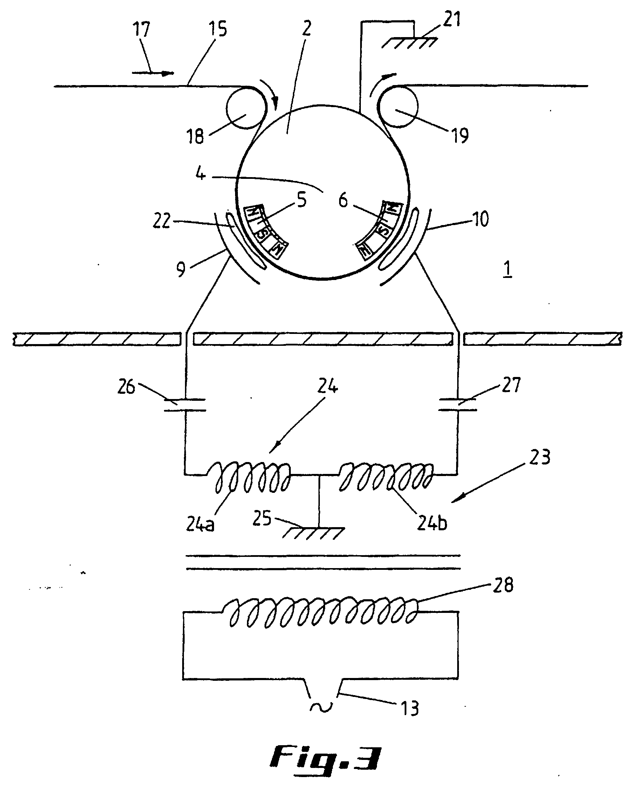

La figure 3 concerne une installation suivant une troisième forme de réalisation qui se différencie essentiellement des précédentes par le fait que l'on applique un courant alternatif à la paire d'électrodes 9 et 10 au moyen d'un générateur 13 par l'intermédiaire d'un transformateur 23 comportant un bobinage secondaire 24 formé de deux parties en série 24a et 24b dont une des extrémités est maintenue à un potentiel connu fixe, par exemple à la masse, comme indiqué en 25 sur la figure 3, et dont l'autre extrémité de ces parties 24a et 24b est reliée par l'intermédiaire de condensateurs 26, respectivement 27, aux contre-électrodes respectivement 9 et 10.

Le générateur d'énergie, notamment de courant alternatif, 13 est branché sur le bobinage primaire 28 du transformateur 23.

Afin d'obtenir une répartition équilibrée entre l'alimentation vers les deux contre-électrodes 9 et 10, les deux parties précitées 24a et 24b du bobinage secondaire 24 sont identiques et présentent le même nombre de spires. Ces parties sont reliées aux contre-électrodes respectives 9 et 10 par l'intermédiaire de condensateurs 26, respectivement 27, qui sont également identiques du point de vue de leurs propriétés capacitives.

L'extrémité des deux parties 24a et 24b du bobinage secondaire 24, qui n'est pas raccordé au condensateur respectif, est avantageusement maintenue au même potentiel que le substrat 15. Dans le présent cas, comme déjà indiqué ci-dessus, aussi bien le substrat que cette extrémité sont raccordés à la masse.

Si l'on fait usage d'un tambour dont la surface cylindrique est conductrice d'électricité, le raccordement à la masse peut être effectué par l'intermédiaire de ce tambour, comme montré à la figure 3.

Dans une forme de réalisation particulière suivant l'invention, pour le traitement d'une bande métallique telle que de l'acier doux, de l'aluminium ou de l'acier inoxydable, on fait avantageusement usage d'un mélange gazeux d'argon et d'un gaz éventuellement réactif tel que de l'hydrogène ou de l'oxygène, dont la teneur peut varier entre 5 et 50 % en volume.

La pression régnant à l'intérieur de la chambre sous vide est par exemple maintenue à 5x10⁻³ Torr.

Le magnétron utilisé est un magnétron classique permettant le confinement des électrons à la surface de la bande métallique se déplaçant dans les zones en regard des contre-électrodes.

La source de puissance alternative est constituée d'un générateur de courant alternatif dont la fréquence peut varier de 10 KHz à 100 KHz.

Dans certains cas, on peut faire usage d'argon pur ou d'hydrogène pur.

L'objet de l'invention est illustré davantage par les exemples concrets de réalisation donnés ci-après.

### Exemple 1

Décontamination par décapage magnétron moyenne fréquence d'une tôle d'acier doux présentant une forte contamination sous forme d'un film d'huile avant le revêtement sous vide par un film d'étain.

### Description des conditions de travail pour le traitement d'une face :

La vitesse de ligne est de 500 m/min ;
Trois unités du type de celle présentée à la figure 1 sont nécessaires ;
chaque paire de contre-électrodes est reliée à un générateur HF de 40 kHz permettant de dissiper une puissance de travail de 200 kW. ;
Les deux premières unités sont alimentées par un mélange de 80 % d'Ar et de 20 % d'O₂ et le débit gazeux est fixé de manière telle que la pression de travail soit de 5.10⁻³ Torr permettant ainsi l'oxydation de la couche d'huile.
La troisième unité est alimentée par un mélange de 80 % d'Ar et de 20 % d'H₂ et la pression de travail est de 5.10⁻³ Torr de manière à obtenir la réduction de la couche FeO, présente à la surface de la tôle, d'une épaisseur de l'ordre de 5 nm.

Après ce traitement, la tôle ne présente plus de contamination carbonée et est dépourvue de sa couche d'oxydation.

### Exemple 2

Traitement d'activation de la surface d'un film de polyéthylène de 20 µm d'épaisseur dans un mélange d'oxygène et d'argon avant le dépôt d'un film de SiO₂.

### Description des conditions de travail :

Une seule unité du type de la figure 1 est nécessaire ;
La vitesse de ligne est de 400 m/min.
Chacun des deux générateurs délivre une puissance utile de 50 kW à une fréquence de 300 kHz.
La décharge est réalisée dans un mélange de 70% d'Ar et de 30% de O₂ à une pression de 5.10⁻² torr.
Ce traitement permet d'améliorer l'adhésion du film de SiO₂.

Il est bien entendu que l'invention n'est pas limitée aux formes de réalisation décrites ci-dessus et que d'autres variantes peuvent être envisagées aussi bien en ce qui concerne la construction de l'installation que des conditions opératoires du procédé appliqué.

## Revendications

1. Procédé pour le décapage en continu de la surface d'un substrat se déplaçant dans un sens déterminé à travers une chambre sous vide en regard d'au moins une contre-électrode, suivant lequel on crée, entre cette dernière et cette surface, un plasma dans un gaz de manière à générer des radicaux et/ou ions pouvant agir sur ladite surface à décaper, **caractérisé en ce que** l'on fait usage dans la chambre susdite d'au moins une paire de contre-électrodes successives en regard de laquelle se déplace le substrat susdit, **en ce que** l'on applique à ces contre-électrodes un potentiel alternatif de manière à imposer un potentiel à ces dernières alternativement positif et négatif par rapport au substrat, ladite au moins une paire de contre-électrode comprenant une première contre-électrode et une deuxième contre-électrode, la première contre-électrode étant polarisée positivement par rapport au substrat lorsque la deuxième contre-électrode l'est négativement, et inversement, et **en ce que**, sur la surface du substrat en regard de la ou des contre-électrodes polarisées positivement par rapport à lui, a lieu un bombardement d'ions positifs issu du plasma créé entre le substrat et ce ou ces contre-électrodes.

2. Procédé suivant la revendication 1, **caractérisé en ce que** l'on impose aux contre-électrodes alternativement un potentiel positif et négatif présentant sensiblement une même valeur absolue par rapport au potentiel du substrat, tel qu'un potentiel variant sinusoïdalement par rapport à celui du substrat.

3. Procédé suivant l'une ou l'autre des revendications 1 et 2, **caractérisé en ce que** l'on applique un courant alternatif à la paire d'électrodes susdites par l'intermédiaire d'un transformateur comportant un bobinage secondaire formé de deux parties en série dont une des extrémités est maintenue à un potentiel connu fixe, l'autre extrémité d'une desdites parties étant reliée, éventuellement par l'intermédiaire d'un condensateur, à une des contre-électrodes, l'autre extrémité de l'autre partie étant reliée, éventuellement par l'intermédiaire d'un condensateur, à l'autre contre-électrode.

4. Procédé suivant la revendication 3, **caractérisé en ce que** l'on fait usage d'un transformateur dont les deux parties précitées du bobinage secondaire sont sensiblement identiques qui sont reliées à la contre-électrode respective par l'intermédiaire de condensateurs également sensiblement identiques du point de vue propriétés capacitives.

5. Procédé suivant l'une ou l'autre des revendications 3 et 4, **caractérisé en ce que** l'on maintient une des extrémités des deux parties du bobinage secondaire sensiblement au même potentiel que le substrat

6. Procédé suivant l'une quelconque des revendications 1 à 5, **caractérisé en ce que** l'on maintient le substrat à la masse.

7. Procédé suivant l'une quelconque des revendications 1 à 6, **caractérisé en ce que** l'on prévoit, par contre-électrode, un circuit magnétique servant au confinement des électrons du plasma et disposé derrière la face à décaper du substrat et en regard de chacune de ces contre-électrodes.

8. Procédé suivant l'une quelconque des revendications 1 à 7, **caractérisé en ce que** l'on applique aux contre-électrodes un potentiel alternatif ayant une fréquence de 1 Hz à 1000 KHz.

9. Procédé suivant la revendication 8, **caractérisé en ce que**, lorsque la surface à décaper est électriquement conductrice et est, par exemple, réalisée en métal, l'on applique aux contre-électrodes un potentiel alternatif de 50 Hz à 300 KHz et de préférence de 10 KHz à 100 KHz.

10. Procédé suivant l'une quelconque des revendications 1 à 9, **caractérisé en ce que** le substrat est formé d'une bande continue d'acier, de préférence d'acier doux, d'aluminium ou d'acier inoxydable.

11. Installation pour la mise en oeuvre du procédé suivant l'une quelconque des revendications 1 à 10, comprenant une chambre sous vide dans laquelle est montée une contre-électrode, des moyens de transport pour déplacer un substrat à décaper en regard de celle-ci, et des moyens pour créer un plasma entre la contre-électrodes et le substrat, dans un gaz permettant de générer des radicaux et/ou ions pouvant agir sur la surface du substrat à décaper orientée vers ladite contre-électrode, **caractérisé en ce qu'**elle comprend au moins une paire de contre-électrodes successives, des moyens pour appliquer à ces contra-électrodes un potentiel ou courant alternatif, de manière à charger ces dernières alternativement positivement et négativement par rapport audit substrat, les moyens pour créer un plasma permettant de créer celui-ci alternativement entre une de ces contra-électrodes et le substrat faisant face à celle-ci, ladite au moins une paire de contre-électrodes comprenant une première contre-électrode et une deuxième contre-électrode et les moyens pour appliquer un potentiel ou courant alternatif à ces contre-électrodes étant prévus pour charger la première contre-électrode positivement et la seconds contre-électrode négativement, par rapport au substrat, et inversement.

12. Installation pour la mise en oeuvre du procédé suivant la revendication 11, **caractérisé en ce qu'**il comprend en outre au moins un circuit magnétique servant au confinement des électrons du plasma et disposé derrière la surface à décaper du substrat et en regard d'au moins une des contre-électrodes.

## Patentansprüche

1. Verfahren zum kontinuierlichen Ätzen der Oberfläche eines Substrats, das sich in einer bestimmten Richtung durch eine Vakuumkammer gegenüber mindestens einer Gegenelektrode bewegt, gemäß welchem, zwischen dieser letzteren und dieser Oberfläche, ein Plasma in einem Gas derart erzeugt wird, daß Radikale und/oder Ionen erzeugt werden, die auf die zu ätzende Oberfläche einwirken können,
**dadurch gekennzeichnet,**
**daß** in der vorstehend genannten Kammer mindestens ein Paar von aufeinanderfolgenden Gegenelektroden verwendet wird, gegenüber welchem sich das vorstehend genannte Substrat bewegt, dadurch, daß an diese Gegenelektroden ein Wechselpotential in der Weise angelegt wird, daß diesen letzteren ein in Bezug auf das Substrat abwechselnd positives und negatives Potential auferlegt wird, wobei das mindestens eine Paar von Gegenelektroden eine erste Gegenelektrode und zweite Gegenelektrode umfaßt, wobei die erste Gegenelektrode in Bezug auf das Substrat positiv polarisiert ist, wenn die zweite Gegenelektrode negativ polarisiert ist, und umgekehrt, und dadurch, daß, an der Oberfläche des Substrats gegenüber der in Bezug auf dasselbe positiv polarisierten Gegenelektrode oder gegenüber der in Bezug auf dasselbe positiv polarisierten Gegenelektroden, ein Bombardement von aus dem zwischen dem Substrat und dieser Gegenelektrode oder diesen Gegenelektroden erzeugten Plasma hervorgegangenen positiven Ionen stattfindet.

2. Verfahren nach Anspruch 1, **dadurch gekennzeichnet, daß** den Gegenelektroden abwechselnd ein positives Potential und ein negatives Potential, die im wesentlichen denselben Absolutwert in Bezug auf das Potential des Substrats aufweisen, auferlegt wird, wie beispielsweise ein in Bezug auf das Potential des Substrats sinusförmig variierendes Potential.

3. Verfahren nach einem der Ansprüche 1 oder 2, **dadurch gekennzeichnet, daß** ein Wechselstrom an das Paar der vorstehend genannten Elektroden angelegt wird mittels eines Transformators, der eine Sekundärspule aufweist, welche aus zwei Teilen in Reihe gebildet ist, deren eines Ende auf einem festen bekannten Potential gehalten wird, wobei das andere Ende von einem der Teile, eventuell über einen Kondensator, mit einer der Gegenelektroden verbunden ist und wobei das andere Ende des anderen Teils, eventuell über einen Kondensator, mit der anderen Gegenelektrode verbunden ist.

4. Verfahren nach Anspruch 3, **dadurch gekennzeichnet, daß** ein Transformator verwendet wird, von dem die zwei vorstehend genannten Teile der Sekundärspule, welche mit der jeweiligen Gegenelektrode über Kondensatoren, die hinsichtlich ihrer kapazitiven Eigenschaften ebenfalls im wesentlichen identisch sind, verbunden sind, im wesentlichen identisch sind.

5. Verfahren nach einem der Ansprüche 3 oder 4, **dadurch gekennzeichnet, daß** eines der Enden der zwei Teile der Sekundärspule im wesentlichen auf demselben Potential wie das Substrat gehalten wird.

6. Verfahren nach einem der Ansprüche 1 bis 5, **dadurch gekennzeichnet, daß** das Substrat auf Masse gehalten wird.

7. Verfahren nach einem der Ansprüche 1 bis 6, **dadurch gekennzeichnet, daß** bei der Gegenelektrode ein Magnetkreis vorgesehen ist, der zur Abschirmung der Elektronen des Plasmas dient und hinter der zu ätzenden Fläche des Substrats und gegenüber jeder dieser Gegenelektroden angeordnet ist.

8. Verfahren nach einem der Ansprüche 1 bis 7, **dadurch gekennzeichnet, daß** an die Gegenelektroden ein Wechselpotential angelegt wird, das eine Frequenz von 1 Hz bis 1000 KHz aufweist.

9. Verfahren nach Anspruch 8, **dadurch gekennzeichnet, daß**, wenn die zu ätzende Oberfläche elektrisch leitfähig ist und, beispielsweise, aus Metall hergestellt ist, an die Gegenelektroden ein Wechselpotential von 50 Hz bis 300 KHz und vorzugsweise von 10 KHz bis 100 KHz angelegt wird.

10. Verfahren nach einem der Ansprüche 1 bis 9, **dadurch gekennzeichnet, daß** das Substrat aus einem kontinuierlichen Band aus Stahl, vorzugsweise aus weichem Stahl, aus Aluminium oder aus rostfreiem Stahl gebildet ist.

11. Vorrichtung zur Durchführung des Verfahrens nach einem der Ansprüche 1 bis 10, umfassend eine Vakuumkammer, in der eine Gegenelektrode, Transportmittel zum Bewegen eines zu ätzenden Substrates gegenüber derselben und Mittel zum Erzeugen eines Plasmas zwischen der Gegenelektrode und dem Substrat in einem Gas, welches es erlaubt, Radikale und/oder Ionen zu erzeugen, die auf die gegen die Gegenelektrode gerichtete Oberfläche des zu ätzenden Substrats einwirken können, angeordnet sind, **dadurch gekennzeichnet, daß** die Vorrichtung mindestens ein Paar von aufeinanderfolgenden Gegenelektroden, Mittel zum Anlegen eines Wechselpotentials oder eines Wechselstroms an diese Gegenelektroden in der Weise, daß diese letzteren abwechselnd positiv und negativ in Bezug auf das Substrat geladen werden, wobei die Mittel zum Erzeugen eines Plasmas es erlauben, dasselbe abwechselnd zwischen einer dieser Gegenelektroden und dem derselben gegenüberliegenden Substrat zu erzeugen, wobei das mindestens eine Paar von Gegenelektroden eine erste Gegenelektrode und eine zweite Gegenelektrode umfaßt und die Mittel zum Anlegen eines Wechselpotentials oder eines Wechselstroms an diese Gegenelektroden dazu vorgesehen sind, die erste Gegenelektrode positiv und die zweite Gegenelektrode negativ in Bezug auf das Substrat zu laden, und umgekehrt.

12. Vorrichtung zur Durchführung des Verfahrens nach Anspruch 11, **dadurch gekennzeichnet, daß** sie ferner mindestens einen Magnetkreis umfaßt, der zur Abschirmung der Elektronen des Plasmas dient und hinter der zu ätzenden Oberfläche des Substrats und gegenüber mindestens einer der Gegenelektroden angeordnet ist.

## Claims

1. Process for continuously stripping the surface of a substrate moving in a defined direction through a vacuum chamber past at least one counterelectrode, according to which process a plasma is created in a gas, between this counterelectrode and this surface, so as to generate radicals and/or ions which can act on the said surface to be stripped, **characterised in that** at least one pair of successive counterelectrodes, past which the abovementioned substrate moves, is used in the vacuum chamber, **in that** an alternating potential is applied to these counterelectrodes so as to impose on the latter an alternately positive and negative potential with respect to the substrate, said at least one pair of counterelectrodes comprising a first counterelectrode and a second counterelectrode, the first counterelectrode being biased positively with respect to the substrate when the second counterelectrode is biased negatively, and inversely, and **in that** a bombardment by positive ions from the plasma created between the substrate and this or these counterelectrode(s) takes place on the substrate surface opposite the counterelectrodes which are positively biased with respect thereto.

2. Process according to Claim 1, **characterised in that** a positive and negative potential having approximately the same absolute value with respect to the potential of the substrate is alternately imposed on the counterelectrodes, such as a potential varying sinusoidally with respect to that of the substrate.

3. Process according to either of Claims 1 and 2, **characterised in that** an alternating current is applied to the pair of abovementioned electrodes by means of a transformer having a secondary winding formed from two parts in series, one of the ends of which is maintained at a fixed known potential, the other end of one of the said parts being connected, optionally via a capacitor, to one of the counterelectrodes and the other end of the other part being connected, optionally via a capacitor, to the other counterelectrode.

4. Process according to Claim 3, **characterised in that** a transformer, the two aforementioned parts of the secondary winding of which are substantially identical and are connected to the respective counterelectrode via capacitors which are also substantially identical from the capacitive properties standpoint, is used.

5. Process according to either of Claims 3 and 4, **characterised in that** one of the ends of the two parts of the secondary winding is maintained at substantially the same potential as the substrate.

6. Process according to any one of Claims 1 to 5, **characterised in that** the substrate is maintained at earth potential.

7. Process according to any one of Claims 1 to 6, **characterised in that** each counterelectrode is provided with a magnetic circuit serving to confine the electrons of the plasma and placed behind that face each of the substrate which is to be stripped and opposite each of these counterelectrodes.

8. Process according to any one of Claims 1 to 7, **characterised in that** an alternating potential having a frequency of 1 Hz to 1000 kHz is applied to the counterelectrodes.

9. Process according to Claim 8, **characterised in that**, when the surface to be stripped is electrically conductive and is, for example, made of metal, a 50 Hz to 300 kHz, preferably 10 kHz to 100 kHz, alternating potential is applied to the counterelectrodes.

10. Process according to any one of Claims 1 to 9, **characterised in that** the substrate is formed by a continuous steel, preferably mild-steel, aluminium or stainless-steel, strip.

11. Apparatus for implementing the process according to any one of Claims 1 to 10, comprising a vacuum chamber in which a counterelectrode is mounted, transportation means for moving a substrate to be stripped past this counterelectrode, and means for creating a plasma between the counterelectrode and the substrate in a gas which is such as to generate radicals and/or ions which can act on that surface of the substrate to be stripped which is turned towards the said counterelectrode, **characterised in that** said apparatus comprises at least one pair of successive counterelectrodes, means allowing an alternating potential or current to be applied to these counterelectrodes, so as to charge the latter alternately positively and negatively with respect to the said substrate, the means for creating a plasma allowing to create it alternatively between one of said counterelectrodes and the substrate opposite the latter, said at least one pair of counterelectrodes comprising a first counterelectrode and a second counterelectrode and the means for applying an alternating potential or current to said counterelectrodes being provided for biasing positively the first counterelectrode and negatively the second counterelectrode with respect to the substrate, and inversely.

12. Apparatus for implementing the process according to Claim 11, **characterised in that** it comprises further at least one magnetic circuit serving to confine the electrons of the plasma and placed behind the surface to be stripped of the substrate and opposite at least one of the counterelectrodes.
